# EUROPEAN PATENT APPLICATION

(11) **EP 4 560 335 A1**
(43) Date of publication of application: **28.05.2025**
(21) Application number: 23211418.1
(22) Date of filing: 22.11.2023
(51) Int. Cl.: G01R 31/392, G01R 31/396, G01R 31/389

(54) **IN-SITU EIS**

(71) Applicant: VOLVO TRUCK CORPORATION, 405 08 Göteborg (SE)
(72) Inventor: LIDSTRÖM, Emil, 423 56 Torslanda (SE)
(74) Representative: Ström & Gulliksson AB

(57) **Abstract**

A computer system (**100**) comprising processing circuitry (**110**) is presented. The processing circuitry (**110**) is configured to, during control, by the processing circuitry (**110**), of an electrical connection between a battery pack (**200**) and a traction system (**12**) of a vehicle (**10**) at a first switching frequency (**351**) of a set of predetermined switching frequencies, synchronously obtain a first cell voltage (**321**) and a first cell current (**331**) of a battery cell (**210**) of the battery pack (**200**); and provide the first cell voltage (**321**), the first cell current (**331**) and the first switching frequency (**351**) for diagnostic of the battery cell (**210**).

## Description

### TECHNICAL FIELD

The disclosure relates generally to diagnostics of battery cells. In particular aspects, the disclosure relates to in-situ diagnostics of battery cells by EIS. The disclosure can be applied to heavy-duty vehicles, such as trucks, buses, nautical vehicles and construction equipment, among other vehicle types. Although the disclosure may be described with respect to a particular vehicle, the disclosure is not restricted to any particular vehicle.

### BACKGROUND

Batteries are used in numerous applications, from simple devices as flashlights to advanced power systems for vehicles. Batteries generally have a limited lifetime that depends on their usage and several techniques exist to estimate internal data of a battery.

The internal data may describe a sate of charge (SOC), a state of health (SOH) or other data used to diagnose the battery. Correct and accurate estimation of internal data is important in order to enable efficient and healthy operation of the battery.

### SUMMARY

According to a first aspect of the disclosure, a computer system comprising processing circuitry is presented. The processing circuitry is configured to during control, by the processing circuitry, of an electrical connection between a battery pack and a traction system of a vehicle at a first switching frequency of a set of predetermined switching frequencies, synchronously obtain a first cell voltage and a first cell current of a battery cell of the battery pack. The processing circuitry is further configured to provide the first cell voltage, the first cell current and the first switching frequency for diagnostic of the battery cell. A technical benefit may include being able to provide in-situ, i.e. during operation, EIS data from a battery pack or battery cell. This enables improved diagnostic capabilities, increased lifetime of batteries, better estimating of SOC, SOH etc. A further technical benefit may include enabling obtaining of EIS data without requirement for specialized hardware, EIS data may be provided utilizing hardware generally present at a vehicle.

Optionally in some examples, including in at least one preferred example, the processing circuitry is further configured to: during control, by the processing circuitry, of an electrical connection between a battery pack and a traction system of a vehicle at each additional switching frequency of the set of predetermined switching frequencies, for each additional switching frequency, synchronously obtain an additional cell voltage and an additional cell current of a battery cell of the battery pack. The processing circuitry is further configured to provide the additional cell voltages, the additional cell currents and their associated additional switching frequencies for diagnostic of the battery cell. A technical benefit may include providing the EIS data across a spectrum of frequencies, i.e. and EIS spectrum which enables further improved diagnostic capabilities, increased lifetime of batteries, better estimating of SOC, SOH etc.

Optionally in some examples, including in at least one preferred example, the set of predetermined switching frequencies comprise one or more frequencies between 0,1 Hz to 10 kHz. A technical benefit may include enabling improved diagnostic capabilities, increased lifetime of batteries, better estimating of SOC, SOH etc.

Optionally in some examples, including in at least one preferred example, the processing circuitry is further configured to control the electrical connection between the battery pack and the traction system by controlling pre-charge transistor circuitry of the battery pack. A technical benefit may include decreasing a cost of providing in-situ EIS data as no additional hardware is required.

Optionally in some examples, including in at least one preferred example, the processing circuitry is further configured to, prior to obtaining the cell voltages and cell currents control the traction system to provide a short circuit to the battery pack; and control the pre-charge transistor circuitry to limit currents from the battery pack. A technical benefit may include decreasing a cost of providing in-situ EIS data as no additional hardware is required and that the controlled load enables improved diagnostic capabilities, increased lifetime of batteries, better estimating of SOC, SOH etc.

Optionally in some examples, including in at least one preferred example, the processing circuitry is further configured to obtain a plurality of first cell voltages as a series of first cell voltages, a plurality of first cell currents as a series of first cell currents synchronous to the series of first cell voltages; obtain, for each additional frequency of the set of predetermined switching frequencies, additional cell voltages as a series of additional cell voltages and a plurality of additional cell currents as a series of additional cell currents synchronous to the series of additional cell voltages, filter the series of first cell voltages and the series of first cell currents by a first filter, wherein the first filter is tuned to the first switching frequency, and filter, for each additional frequency of the set of predetermined switching frequencies, the series of additional cell voltage and the series additional cell currents by an additional filter, wherein the additional filter is tuned to the associated additional switching frequency. A technical benefit may include enabling improved diagnostic capabilities, increased lifetime of batteries, better estimating of SOC, SOH etc.

Optionally in some examples, including in at least one preferred example, the processing circuitry is further configured to diagnose the battery pack based on the obtained cell voltage/s, the obtained cell current/s and their associated switching frequency/ies, preferably by determining current state of health, SOH, of the battery pack and compare the current SOH to a previous SOH of the battery pack. A technical benefit may include enabling improved diagnostic capabilities, increased lifetime of batteries, better estimating of SOC, SOH etc.

Optionally in some examples, including in at least one preferred example, the processing circuitry is further configured to control operation of the battery pack based on the obtained cell voltage/s, the obtained cell current/s and their associated switching frequency/ies. A technical benefit may include enabling improved diagnostic capabilities, increased lifetime of batteries, better estimating of SOC, SOH etc.

Optionally in some examples, including in at least one preferred example, the processing circuitry is further configured to: during control, by the processing circuitry, of an electrical connection between a battery pack and a traction system of a vehicle at each additional switching frequency of the set of predetermined switching frequencies, for each additional switching frequency, synchronously obtain an additional cell voltage and an additional cell current of a battery cell of the battery pack; and provide the additional cell voltages, the additional cell currents and their associated additional switching frequencies for diagnostic of the battery cell; control the electrical connection between the battery pack and the traction system by controlling pre-charge transistor circuitry of the battery pack; control the traction system to provide a short circuit to the battery pack; and control the pre-charge transistor circuitry to limit currents from the battery pack; obtain a plurality of first cell voltages as a series of first cell voltages, a plurality of first cell currents as a series of first cell currents synchronous to the series of first cell voltages; obtain, for each additional frequency of the set of predetermined switching frequencies, additional cell voltages as a series of additional cell voltages and a plurality of additional cell currents as a series of additional cell currents synchronous to the series of additional cell voltages, filter the series of first cell voltages and the series of first cell currents by a first filter, wherein the first filter is tuned to the first switching frequency, and filter, for each additional frequency of the set of predetermined switching frequencies, the series of additional cell voltage and the series additional cell currents by an additional filter, wherein the additional filter is tuned to the associated additional switching frequency; diagnose the battery pack based on the obtained cell voltage/s, the obtained cell current/s and their associated switching frequency/ies, preferably by determining current state of health, SOH, of the battery pack and compare the current SOH to a previous SOH of the battery pack; control operation of the battery pack based on the obtained cell voltage/s, the obtained cell current/s and their associated switching frequency/ies; wherein the set of predetermined switching frequencies comprise one or more frequencies between 0,1 Hz to 10 kHz; and wherein the processing circuitry is further configured to: process the first cell voltage and the first cell current to provide a first frequency internal resistance of the battery cell, and provide the first frequency internal resistance for diagnostic of the battery cell. A technical benefit may include all of the benefits listed above and further enabling improved diagnostic capabilities, increased lifetime of batteries, better estimating of SOC, SOH etc.

According to a second aspect of the disclosure an energy storage system is presented. The energy storage system comprises at least one battery pack, at least one controllable connection between the at least one battery pack and a load and the computer system of the fist aspect operatively connected to the controllable connection. A technical benefit may include being able to provide in-situ, i.e. during operation, EIS data from a battery pack or battery cell. This enables improved diagnostic capabilities, increased lifetime of batteries, better estimating of SOC, SOH etc.

According to a third aspect of the disclosure, a vehicle is presented. The vehicle, comprises a traction system and the energy storage system of the second aspect connected to the traction system. A technical benefit may include all of the benefits listed above and further enabling improved diagnostic capabilities, increased lifetime of batteries, better estimating of SOC, SOH etc.

According to a fourth aspect of the disclosure, a computer implemented method is presented. The method comprising: controlling, by processing circuitry of a computer system, an electrical connection between a battery pack and a traction system of a vehicle at a first switching frequency of a set of predetermined switching frequencies, during control of the electrical connection, synchronously obtaining, by the processing circuitry of the computer system, a first cell voltage and a first cell current of a battery cell of the battery pack; and providing, by the processing circuitry of the computer system, the first cell voltage, the first cell current and the first switching frequency for diagnostic of the battery cell. A technical benefit may include being able to provide in-situ, i.e. during operation, EIS data from a battery pack or battery cell. This enables improved diagnostic capabilities, increased lifetime of batteries, better estimating of SOC, SOH etc.

Optionally in some examples, including in at least one preferred example, the computer implemented method further comprises: controlling, by the processing circuitry of the computer system, the electrical connection between the battery pack and the traction system of the vehicle at each additional switching frequency of the set of predetermined switching frequencies; and during control of the electrical connection, for each additional switching frequency, synchronously obtaining, by the processing circuitry of the computer system, an additional cell voltage and an additional cell current of a battery cell of the battery pack; and providing, by the processing circuitry of the computer system, the additional cell voltages, the additional cell currents and their associated additional switching frequencies for diagnostic of the battery cell. A technical benefit may include providing the EIS data across a spectrum of frequencies, i.e. and EIS spectrum which enables further improved diagnostic capabilities, increased lifetime of batteries, better estimating of SOC, SOH etc.

According to a sixth aspect of the disclosure, a computer program product comprising program code is presented. The program code is for performing, when executed by a processing circuitry, the computer implemented method of the fifth aspect. A technical benefit may include providing the EIS data across a spectrum of frequencies, i.e. and EIS spectrum which enables further improved diagnostic capabilities, increased lifetime of batteries, better estimating of SOC, SOH etc.

According to a seventh aspect of the disclosure, a non-transitory computer-readable storage medium comprising instructions, which when executed by a processing circuitry, cause the processing circuitry to perform the computer implemented method of the fifth aspect. A technical benefit may include providing the EIS data across a spectrum of frequencies, i.e. and EIS spectrum which enables further improved diagnostic capabilities, increased lifetime of batteries, better estimating of SOC, SOH etc.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

Examples are described in more detail below with reference to the appended drawings.
**FIG. 1** is an exemplary side view of a vehicle according to an example.
**FIG. 2** is an exemplary block diagram of a vehicle according to an example.
**FIG. 3A** is an exemplary block diagram of a computer system connected to a battery pack, a switch device and a load according to an example.
**FIG. 3B** is an exemplary block diagram of a computer system connected to a load and a battery pack comprising switch devices.
**FIG. 4** is an exemplary block diagram of a battery pack according to an example.
**FIG. 5** is an exemplary block diagram of an EIS controller according to an example.
**FIG. 6** is an exemplary block diagram of a computer system connected to a battery pack, a switch device and a load according to an example.
**FIG. 7** is an exemplary block diagram of a method according to an example.
**FIG. 8** is an exemplary block diagram of an energy storage system according to an example.
**FIG. 9** is an exemplary block diagram of a vehicle according to an example.
**FIG. 10** is an exemplary block diagram of a battery pack according to an example.
**FIG. 11** is an exemplary block diagram of a computer program product according to an example.
**FIG. 12** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

In order to accurately estimate a remaining capacity, a state of charge (SOC), or other characteristics (e.g. temperature, internal faults etc.) of a battery pack or a battery cell, detailed data of the battery is required. Some solutions estimate an internal resistance of the battery, determine a voltage drop during loading, or simply monitor a current cell voltage to estimate the SOC of the battery. The SOC may be estimated based on a model of the battery where current data is mapped onto the model to estimate a current SOC. Generally the more data that may be provided, the better an estimation of a current state of a battery e.g. SOC, state of health SOH etc. A battery pack may comprise a plurality of battery cells and accurate data of the battery pack may be utilized to provide estimates of the battery cells regarding e.g. SOC, SOH, temperature, voltage, current, internal resistance, rate of self-discharge, peak discharge current etc.

If a battery is disconnected from its load and brought into a testing environment, detailed analysis of the battery may be performed to accurately determine a state of the battery. Some of these analysis are generally destructive, such as half-cell analysis and other are complex requiring specialized equipment and complex test setups such as electrochemical impedance spectroscopy (EIS).

EIS is a powerful technique for studying an electrochemical processes that occur in batteries. EIS generally works by applying an alternating current (AC) signal of controlled amplitude to the battery and synchronously measuring resulting AC voltage and AC current responses. The impedance of the battery is then calculated from a relationship between the resulting AC voltage to the resulting AC current.

EIS is useful in studying a wide range of battery phenomena. EIS may be used to determine charge transfer kinetics of the battery, i.e. the rate at which ions are transferred between the electrodes and the electrolyte. The charge transfer kinetics may be used to optimize the design of battery electrodes and electrolytes. EIS may be useful in determining diffusion of the battery, i.e. the rate at which ions diffuse through the battery electrodes and electrolytes. This information may be used to e.g. improve the performance of batteries at high charge and discharge rates. EIS may further be utilized to determine a solid electrolyte interphase (SEI) formation of the battery, i.e. EIS may be used to monitor the formation and growth of the SEI on the surface of the battery electrodes. The SEI is a thin layer that forms on the electrodes during the first few cycles of battery operation. It plays an important role in protecting the electrodes from degradation and volumetric changes of the electrodes may damage the SEI and cause degrading the electrodes. EIS may further be utilized to determine a battery degradation, i.e. EIS may be used to track changes in e.g. the impedance of the battery over time. These changes can be used to identify and diagnose battery degradation mechanisms. Generally, EIS is a non-destructive technique making it an ideal tool for studying batteries under a variety of operating conditions.

The present disclosure will provide a system, method and other devices configured to obtain EIS data from a battery during use, i.e. in-situ. This allows EIS data to be measured, acquired otherwise obtained without having to disconnect the battery from a load. In an electrical vehicle, very detailed data may be provided without having to remove the battery from the vehicle or discontinue providing power to a load of the battery. This enables improved diagnostic capabilities of the battery. A current SOH, SOC or remaining capacity of the battery may be accurately estimated reducing a risk that the battery is discharged too deeply which may damage the battery. It further allows for more accurate estimates of a remaining distance a battery operated vehicle may travel, it provides more accurate data on when a battery pack, or specific battery cells of a battery pack are in need of maintenance or service.

One specific examples of how EIS may be utilized in a vehicle is to better determine SOC at situations where it is otherwise challenging to accurately estimate the SOC. Chemistries such as LFP and LMFP are typically complicated when it comes to determine SOC from other data. Another specific example of how EIS may be utilized in a vehicle is to better determine an internal temperature of a battery pack. Generally, an amount of sensors configured to obtain data relevant for specific cells of a battery pack are low. Both of these examples are advantageous in optimizing, i.e. increasing an efficiency of, a usage and lifetime of the battery. Specifically, SOC is important for providing the driver optimized range/charging and range estimation.

The present disclosure may be implemented on energy systems comprising multiple battery packs allowing EIS data to be acquired from one battery back whilst other battery packs may provide power to an electrical motor or receive power from a charger. One may note that the current of one battery pack generally affects the current of the other battery packs. That is to say, some EIS analysis may be performed (while driving/charging) on cells in multiple packs while only alternating the connection of one pack.

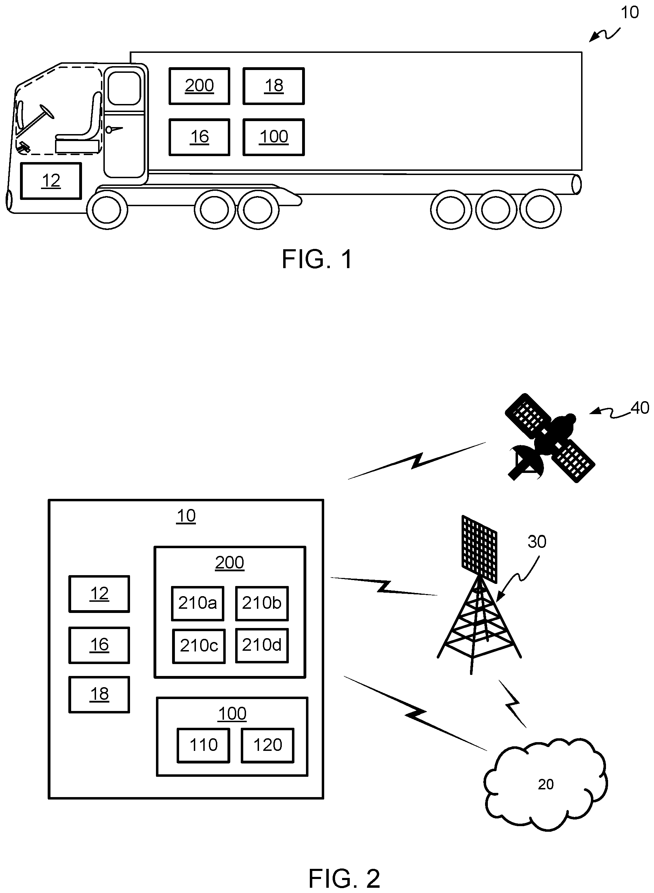

**FIG. 1** is an exemplary schematic side view of a heavy-duty vehicle **10** (hereinafter referred to vehicle **10** for reasons of brevity). This particular vehicle **10** comprises a tractor unit **10a** which is arranged to tow a trailer unit **10b.** In other examples, other heavy-duty vehicles may be employed, e.g., trucks, buses, and construction equipment. Although not explicitly visualized in **FIG. 1****,** the skilled person will appreciate that the vehicle **10** comprises all necessary vehicle units and associated functionality such that it may operate as the skilled person would expect of a vehicle **10,** such as a powertrain, chassis, and various control systems. Emphasis in the present disclosure is rather directed at electrical currents of the vehicle **10,** and therefore functionality and features related this will be the focus of the present disclosure. However, the vehicle **10** comprises one or more propulsion sources **12.** The propulsion source **12** may be any suitable propulsion source **12** exemplified by, but not limited to, one or more or a combination of an electrical motor, a combustion engine such as a diesel, gas or gasoline powered engine. At least one propulsion source **12** is an electrical motor. The vehicle **10** further comprises at least one energy source **200** suitable for providing energy for the propulsion source(s) **12.** That is to say, as at least one propulsion source **12** is an electrical motor, at least one propulsion source **12** is a battery pack **200.** The vehicle **10** further comprises sensor circuitry **16** arranged to detect, measure, sense or otherwise obtain data relevant for operation of the vehicle **10.** The data relevant for operation of the vehicle **10** may be exemplified by, but not limited to, one or more of a voltage of the battery pack **200,** a current provided by the battery pack **200,** a speed of the vehicle **10,** a weight of the vehicle **10,** an inclination of the vehicle **10,** a status (state of charge, fuel level etc.) of the energy source **200** of the vehicle **10** etc. Advantageously, the vehicle **10** further comprises communications circuitry **18** configured for communication with, to the vehicle **10,** external devices. The vehicle **10** further comprises a computer system **100.**

As shown in **FIG. 2****,** the vehicle **10** may communicate with a cloud server **20** using the communications circuitry **18.** The communications circuitry **18** may be configured to communicate with the cloud server **20** directly, or via a communications interface such as a cellular communications interface exemplified by a radio base station **30** in **FIG. 2****.** The cloud server **20** may be any suitable cloud server exemplified by, but not limited to, Amazon Web Services (AWS), Microsoft Azure, Google Cloud Platform (GCP), IBM Cloud, Oracle Cloud Infrastructure (OCI), DigitalOcean, Vultr, Linode, Alibaba Cloud, Rackspace etc. The communications interface is advantageously a wireless communications interface exemplified by, but not limited to, Wi-Fi, Bluetooth, Zigbee, Z-Wave, LoRa, Sigfox, **2**G (GSM, CDMA), **3**G (UMTS, CDMA**2000**), **4**G (LTE), **5**G (NR) etc. The vehicle **10** may further, via the communications circuitry **18,** be operatively connected to a Global Navigation Satellite System (GNSS) **40** exemplified by, but not limited to, global positioning system (GPS), Globalnaya Navigatsionnaya Sputnikovaya Sistema (GLONASS), Galileo, BeiDou Navigation Satellite System, Navigation with Indian Constellation (NavIC) etc. The vehicle **10** may be configured to utilize data obtain from the GNSS **40** to determine a geographical location of the vehicle **10.**

As mentioned, a vehicle **10** according to the present disclosure is an, at least partly, electrically propelled vehicle. To this end, the vehicle **10** of the present disclosure comprises at least one energy source **200** in the form of an electrical energy source **200,** i.e. at least one battery pack **200.** The vehicle battery pack **200** comprises one or more battery cells **210a, 210b, 210c, 210d.** In **FIG. 2****,** the battery pack **200** is shown comprising four battery cells **210a, 210b, 210c, 210d**. However, this is for illustrative purposes, and the battery pack **200** may comprise any number of battery cells **210a, 210b, 210c, 210d**. The battery pack **200** is advantageously configured to provide energy at least to the propulsion source **12** of the vehicle **10.** Additionally, or alternatively, the battery pack **200** may be configured to provide energy to other part components of the vehicle **10** such as, but not limited to, vehicle electronics, climate control of the vehicle **10,** safety functions of the vehicle etc.

The computer system **100** of the vehicle **10** is advantageously operatively connected to the communications circuitry **18,** the sensor circuitry **16,** the battery pack **200** and/or the propulsion source **12** of the vehicle **10.** The computer system **100** comprises processing circuitry **110.** The computer system **100** may comprise a storage device **120,** advantageously a non-volatile storage device such as a hard disk drives (HDDs), solid-state drives (SSDs) etc. In some examples, the storage device **120** is operatively connected to the computer system **100.**

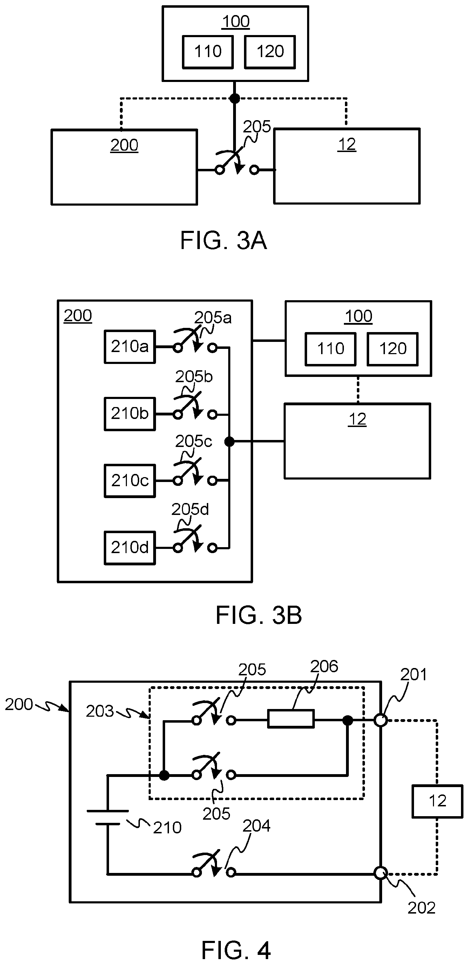

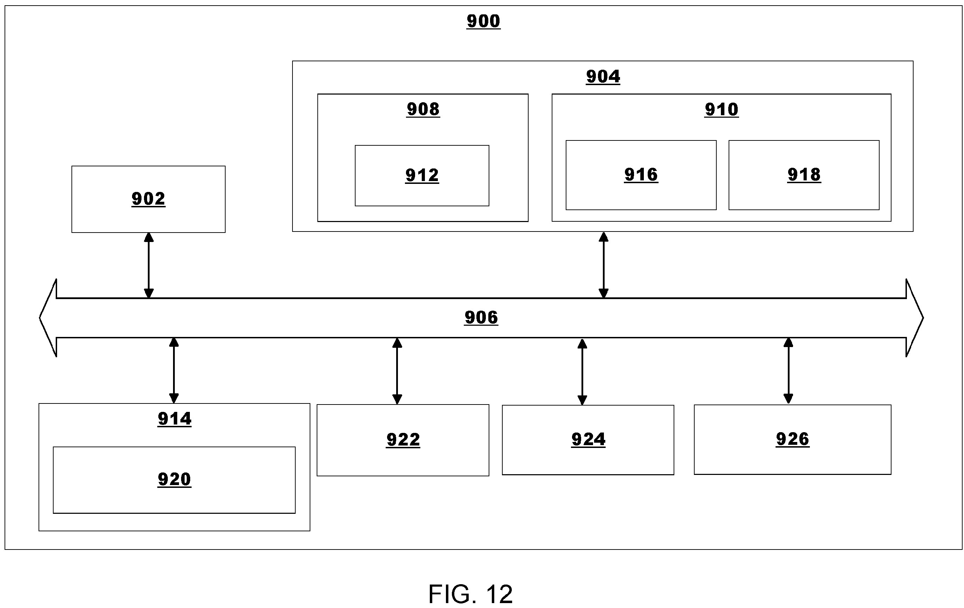

In **FIG. 3A****,** one example of the computer system **100** is shown. In **FIG. 3A****,** the computer system **100** is operatively connected to control a switch device **205** arranged to selectively connect the battery pack **200** to a load **12.** In **FIG. 12****,** the load **12** is the traction system **12,** e.g. the propulsion source **12** of the vehicle **10.**

In **FIG. 3B****,** one example of the computer system **100** is shown. In **FIG. 3B****,** the battery pack **200** is shown comprising a plurality of battery cells **210a, 210b, 210c, 210d.** Each battery cell **210a, 210b, 210c, 210d** is selectively connectable to the load **12** (e.g. the traction system **12** of the vehicle **10**) by a respective switch device **205a, 205b, 205c, 205d.** The computer system **100** is operatively connected to control the switch devices **205a, 205b**, **205c, 205d** arranged to selectively connect the battery pack **200** to a load **12.** Is should be mentioned that, in e.g. vehicle applications, a plurality of cells **210a, 210b, 210c, 210d** are generally connected in series. In such implementations and for the present disclosure, a plurality of cells connected in series may be regarded as one cell.

Regardless of the configuration of the battery pack **200,** and the connection of the computer system **100,** the computer system **100** may advantageously be operatively connected to the battery pack **200** and/or the propulsion source **12.** The processing circuitry **110** of the computer system **100** may be configured to obtain data from the switch device **205,** the battery pack **200** and/or the propulsion source **12.** The data obtained may be exemplified as, but not limited to, a position of the switch device **205,** a mode of operation of the load **12,** a current into/out from the load **12,** a voltage at the load **12,** a current into/out from the switch device **205,** a voltage at the switch device **205,** a current into/out from the battery pack **200** and or a voltage at the battery pack **200** (or cell voltage within the battery pack **200**). Additionally, or alternatively, the processing circuitry **110** of the computer system **100** may be configured to control the switch device **205,** the battery pack **200** and/or the propulsion source **12.** The processing circuitry **110** of the computer system **100** may be configured to control a position (state) of the switch device **205.** The switch device **205** may controllable between two or more positions (states) such as, but not limited to, open, closed, pre-charge etc. The processing circuitry **110** of the computer system **100** may be configured to control the propulsion source **12,** i.e. an electrical machine, to present (provide) a pre-determined load to the switch device **205,** and indirectly to the battery pack **200.** This may be provided by e.g. vector control of an inverter of the electrical machine through which an impedance presented to the switch device **205,** and indirectly to the battery pack **200,** may be controlled. In some examples, the processing circuitry **110** may be configured to present (provide) a pre-determined load to the switch device **205** by controlling a heating element or such device operatively connected to the battery pack **200.**

The examples presented in reference to **FIG. 3A** and **FIG. 3B** should not be considered exhaustive and their respective features may very well be combined. Further to this not all battery cells **210a, 210b, 210c, 210d** are required to be associated with a dedicated switch devices **205a, 205b, 205c, 205d**. In some examples, one or more battery cells **210a, 210b, 210c, 210d** are connected in series and may be selectively connected to the load by a common switch device **205a, 205b, 205c, 205d**. In some examples two or more switch device are connected in parallel and arranged to be selectively connected to the load **12** by a common switch device **205a, 205b, 205c, 205d.** All examples may be suitably combined to form further working examples of the present disclosure.

As shown in **FIG. 4****,** the switch device **205** may form part of a pre-charge circuitry **203** of the battery pack **200.** The pre-charge circuit **203** is provided in order to limit a current flowing into a load during startup of a system. At startup of the system, capacitive part of the load may be completely discharged and the pre-charge circuit **203** will control the current used to charge the capacitive part of the load. In **FIG. 4****,** the pre-charge circuitry **203** is connected to a battery cell **210** of the battery pack **200.** If the battery pack **200** comprise more than one battery cell **210,** all, or some, of the battery cells **210** may be connected to a respective pre-charge circuitry **203.** Further, in some examples, the pre-charge circuitry **203** may be external to the battery pack **200** or arranged such that the same pre-charge circuit **203** is connected to all battery cells **210** of the battery pack **200.** If more than one battery pack **200** is provided, some, or all, battery packs **200** may share a common pre-charge circuitry **203.**

The pre-charge circuitry **205** comprises at least one pre-charge switch **205** and a pre-charge impedance **206.** The pre-charge impedance **206** may be a pre-charge resistor **206.** In **FIG. 4****,** the pre-charge circuitry **203** comprises two pre-charge switches **205,** this is an optional arrangement and in some examples, the pre-charge circuitry **203** comprise only one pre-charge switch **205.** The pre-charge circuitry **203** is configured to selectively connect the battery cell **210** to a load **12** (e.g. the traction system **12** of the vehicle **10**) either directly or through the pre-charge impedance **206.** Generally, as shown in **FIG. 4** the battery pack **200** may comprise further switches **204** arranged to ensure that both poles **201, 202** of the battery pack **210** are disconnected from the battery cell(s) **210.**

In examples of the present disclosure comprising a pre-charge circuitry **203,** the switch devices **205, 205a, 205b, 205c, 205d** introduced with reference to **FIG. 3A** and **FIG. 3B** are advantageously provided by the pre-charge switch **205** of the pre-charge circuitry **203.** This reduces a cost of implementing the teachings presented herein as fewer additional components are required.

It should be mentioned that the switch devices **205, 205a, 205b, 205c, 205d** may be any suitable switch device being capable of controlled switching at switching frequencies of 0, 1 Hz and above. Consequently, the switch devices **205, 205a, 205b, 205c, 205d** may formed as an electromechanical switch such as a relay or even solenoids. However, it is advantageous if the switching frequency may go above 1 kHz, preferably up to 10 kHz. In some examples the switching frequency may go above 10 kHz and even above 50 kHz. At higher frequencies, i.e. above 100 Hz, the switch device **205, 205a, 205b, 205c, 205d** is advantageously a semiconductor based switch such a transistor. Depending on an expected current and switching frequency, different technologies of transistors may be employed such as, but not limited to, bipolar junction transistor (BJT), field-effect transistors (FET), metal-oxide-semiconductor field-effect transistor (MOSFET), insulated gate bipolar junction transistor (IGBT) etc.

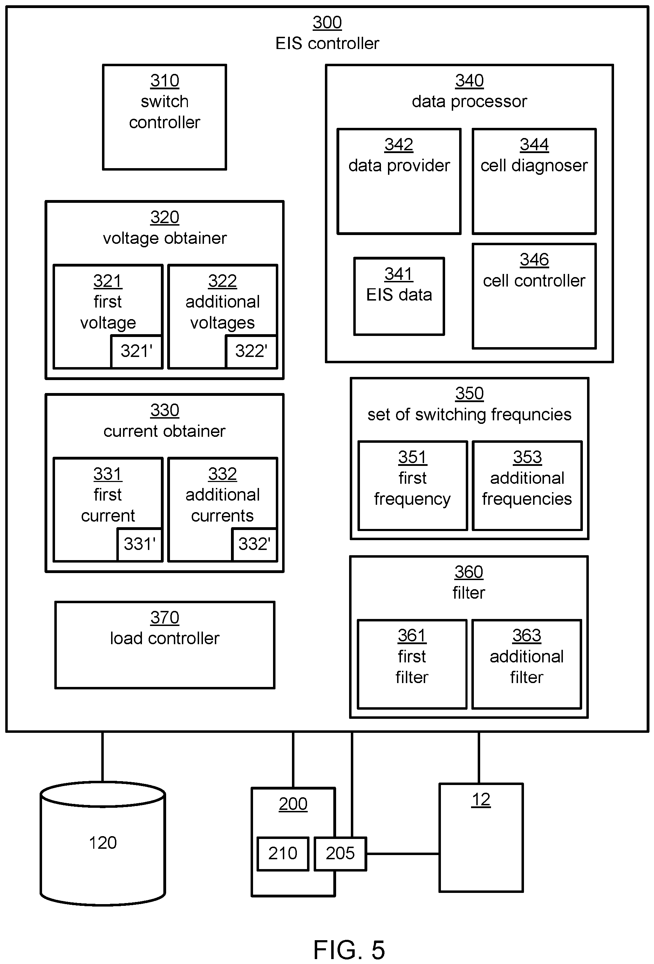

In **FIG. 5****,** a block diagram of an exemplary EIS controller **300** is shown. The EIS controller **300** is configured to provide in-situ, i.e. during use, EIS data **341** for a battery pack **200** and/or a battery cell **210.** The computer system **100,** specifically the processing circuitry **110** of the computer system **100,** may be configured to provide some or all of the functions and features of the EIS controller **300.**

The EIS controller **300** comprises a switch controller **310** configured to control an electrical connection between the battery pack **200,** and/or one or more battery cells **210** of the battery pack **200,** and the load **12.** The control of the electrical connection is advantageously provided by control of a switch device **205** of the battery pack **200** or connected between the battery pack **200** and the load **12.** The control of the electrical connection, e.g. the switch device **205,** is performed at a switching frequency selected from a set of predetermined switching frequencies **350,** a set of switching frequencies **350** for short. The switch controller **310** may be configured to control the electrical connection, e.g. the switch device **205,** at a first frequency **351** of the set of switching frequencies **350** or at one or more additional switching frequencies **353** of the set of switching frequencies **350.** When active, the switch controller **310** is configured to control the switch device **205** at one frequency of the set of switching frequencies **350** at a time. The switch controller **310** may be configured to step through the frequencies **351, 353** of the set of switching frequencies **350.** In some examples, the set of switching frequencies **350** is defined by a frequency range such as 0,1 Hz to 10 kHz, and the switch controller **310** may randomly select the first frequency **351** and optionally any additional frequencies **353** within the frequency range defined by the set of switching frequencies **350.** In some examples, the switch controller **310** may step through the frequency range defined by the set of switching frequencies **350** at a predetermined or random frequency step size. In some examples, the step size is linear. In some examples, the step size is logarithmic.

The EIS controller **300** further comprise a voltage obtainer **320.** The voltage obtainer **320** is configured to obtain, measure or otherwise acquire at least a first voltage **321** of the battery pack **200** or the battery cell **210** for which EIS data **341** is requested. Generally, a voltage relating to a battery cell **210** may be referred to as a cell voltage and a voltage relating to a battery pack **200** may be referred to as a pack voltage. Optionally, the voltage obtainer **320** may be configured to obtain one or more additional voltages **322** of the battery pack **200** or the battery cell **210** for which EIS data **341** is requested. The voltage obtainer **320** may obtain the voltages **321, 322** from e.g. the previously presented sensor circuitry **16,** the battery pack **200** and/or the battery cell **210.** The voltage obtainer **320** may be configured to obtain the first voltage **321** not as one single value at one point in time, but as a series of first voltages **321'** obtained over a time period. Correspondingly, the voltage obtainer **320** may be configured to obtain the additional voltages **322** not as one single value at one point in time, but as a series of additional voltages **322'** obtained over a time period.

The EIS controller **300** further comprise a current obtainer **330.** The current obtainer **330** corresponds to the voltage obtainer **320** but is configured to obtain, measure or otherwise acquire at least a first current **331** of the battery pack **200** or the battery cell **210** for which EIS data **341** is requested. Generally, a current relating to a battery cell **210** may be referred to as a cell current and a current relating to a battery pack **200** may be referred to as a pack current. Optionally, the current obtainer **330** may be configured to obtain one or more additional currents **332** of the battery pack **200** or the battery cell **210** for which EIS data **341** is requested. The current obtainer **330** may obtain the currents **331, 333** from e.g. the previously presented sensor circuitry **16,** the battery pack **200,** the battery cell **210** and/or the switch device **205.** The current obtainer **330** may be configured to obtain the first current **331** not as one single value at one point in time, but as a series of first currents **331'** obtained over a time period. Correspondingly, the current obtainer **330** may be configured to obtain the additional currents **332** not as one single value at one point in time, but as a series of additional currents **332'** obtained over a time period.

The voltage obtainer **320** and the current obtainer **330** are configured to work synchronously. That is to say, the first voltage **321** and the first current **331** are obtained at substantially the same point in time. Correspondingly, any additional voltages **322** and additional currents **332** are obtained at substantially the same respective points in time. The same applies to each value of the series of first voltages **321'** together with the corresponding value of the series of first currents **331',** and each value of the series of additional voltages **322'** together with the corresponding value of the series of additional currents **332'.**

Is should be mentioned that parts, components, devices etc. that need to synchronize the frequency operation (voltage measurement, current measurement, connection-switch-control) are generally already connected to the same processor circuitry, enabling a more optimal and fast operation compared to having the switching control being done comparably far away in the system as it would be if utilizing an inverter.

It should be mentioned that he EIS controller **300** may very well comprise more than one voltage obtainer **320** and one current obtainer **330.** More voltage obtainers **320** and one current obtainers **330** may increase a sampling frequency of the series of voltages **321', 322'** the series of currents **331', 332.** Further to this, if e.g. the switch device **205** is operating at pack level, i.e. as shown in **FIG. 3A** (or several switch devices **205a, 205b, 205c, 205d** area controlled in parallel), one voltage obtainer **320** and one current obtainer **330** may be provided for each battery cells **210a, 210b, 210c, 210d** (or some of the battery cells **210a, 210b, 210c, 210d**) such that EIS data **341** for a plurality of battery cells **210a, 210b, 210c**, 210d may be provided in parallel.

The EIS controller **300** further comprises a data processor **340.** The data processor **340** is configured to form the EIS data **341** such that it comprises a voltage **321, 322** obtained by the voltage obtainer **320** and a synchronously obtained current **331, 332** obtained by the current obtainer **330.** The EIS data **341** further comprises a switching frequency **351, 353** at which the switch controller **310** operated the switch device **205** during the synchronous obtaining of the voltage **321, 322** by the voltage obtainer **320** and the current **331, 332** by the current obtainer **330.**

The data processor **340** may further process the obtained voltages and currents **321, 322, 331, 332** (or series of voltages and currents **321', 322', 331', 332'**) by determining an internal impedance (resistance) of the battery pack **200** or battery cell **210.** The data processor **340** may further process the obtained voltages and currents **321, 322, 331, 332** (or series of voltages and currents **321', 322', 331', 332'**) by determining an internal impedance of the battery pack **200** or battery cell **210.** The determined impedance and/or the internal resistance may be comprised in the EIS data **341.**

In case the voltage obtainer **320** and the current obtainer **330** obtain series of voltages and currents **321', 322', 331', 332'**, the data processor **340** may be configured to filter the series of voltages and currents **321', 322', 331', 332'** by a filter **360.** The filter **360** may separate filters tuned for each of the frequencies of the set of switching frequencies **350** such that a first filter **361** is tuned to the first frequency **351** and additional filters **363** are tuned to the additional frequencies **353.** Advantageously, the filter **360** is a tunable filter such that the data processor **340** may control the filter **360** to tune it to a switching frequency **351, 353** at which the series of voltages and currents **321', 322', 331', 332'** were/is obtained.

The data processor **340** may further process the series of voltages and currents **321', 322', 331', 332'** by determining a mean, a standard deviation, a peak value, a minimum value etc. of the series of voltages and currents **321', 322', 331', 332'.**

The data processor **340** may comprise a data provider **342** configured to provide the EIS data **341** for further processing, storage and /or diagnostic of the battery pack **200** or battery cell **210.** The data provider **342** may be configured to store the EIS data **341** at the storage device **120** of the computer system **100.**

The data processor **340** may further comprise a cell diagnoser **344** configured to diagnose the battery back **200** and/or the battery cell **210** based on the EIS data **341.** Such diagnosis may comprise determining any metric obtained from EIS data **341** such as, but not limited to, an SOH, an SOC, a diffusion, an SEI formation etc. The data determined metrics may be provided to the storage device **120** by the data provide **342** and/or comprised in the EIS data **341.** The cell diagnoser **344** may further be configured to compare a determined metric, including impedance and/or resistance, to corresponding historic metrics (obtained from e.g. the storage device **120**) to determine a rate of deterioration or simply to detect changes in the determined metrics.

The data processor **340** may further comprise a cell controller **345** configured to control the battery pack **200** and/or the battery cell **210** based on the EIS data **341.** Such control may comprise preventing the battery pack **200** or battery cell **210** to be discharged too deeply and/or actively limit a current from a battery cell **210** to provide equal currents from all battery cells **210** of a battery pack **200.**

The EIS controller **300** may further comprise a load controller **370.** The load controller **370** is configured to control the load **12** such that the load **12** presents a desired impedance to the battery switch device **205.** In the preferred example, the load **12** is a traction system **12** of a vehicle **10** and the impedance of the load may be controlled by manipulating and inverter of the traction system **12** to present the desired impedance. The desired impedance may be referred to as a controlled discharge impedance, or discharge impedance for short. For instance, by controlling the inverter not to change phases (in a three-phase inverter), only one winding will be presented to the battery pack **200** which, after charging of the winding, will manifest itself as a short circuit. In order to reduce a risk of damaging the load **12,** the switch controller **310** may be configured to limit a current provided by the battery pack **200** by e.g. PWM-control of the switch device **205** and/or connecting the pre-charge impedance **206** in the flow of current into the load **12.** In some examples, short circuit may be interpreted as low impedance, e.g. an impedance below 25 Ω.

The EIS controller **300** enables provisioning of EIS data **341** during use of a battery pack **200.** In order not to disrupt functionality of the load **12,** it is advantageous to only control, by the switch controller **310,** some of the switch devices **205** between the load **12** and a power source **200, 210.** To exemplify, if the load is an electrical motor (an electrical propulsion source) of the vehicle **10** and the vehicle only comprise one battery pack **200,** controlling a common switch device (see **FIG. 3A**) is likely to affect operation of the vehicle **10.** During stand still, the load controller **370** may be utilized to enable EIS data **341** also in such an example. However, if more than one battery pack **200** is available to provide power to the electrical motor, controlling a switch device **205** of one battery back **200** is unlikely to affect operation of the vehicle **10** as the other battery pack **200** will compensate for any power lost due to switching. Further, if only any battery pack **200** is available (or there are other reasons for not wanting to obtain EIS data **341** on battery pack level), switch devices **205a, 205b, 205c, 205d** of only one or some of the battery cells **210a, 210b, 210c, 210d** may be controller by the switch controller **310** such that EIS data **341** is obtained on a battery cell level. The latter example will also enable acquiring of EIS data **341** during operation of e.g. a vehicle **10,** even if it is being propelled by the electrical motor **12.**

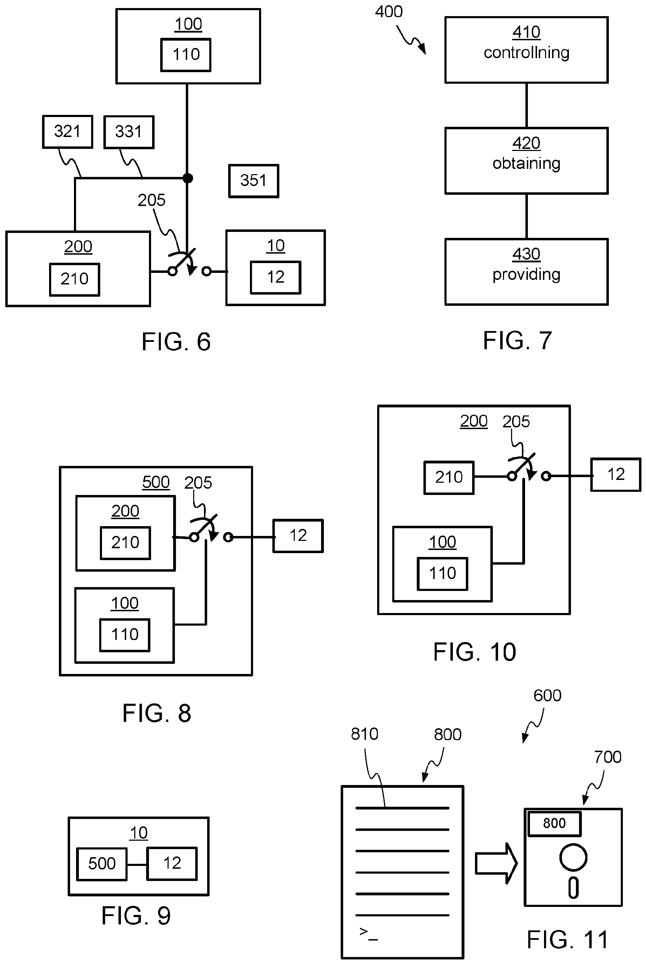

In **FIG. 6** one preferred example of a computer system **100** according to the present disclosure is presented. The computer system **100** comprises processing circuitry **110** configured to, during control, by the processing circuitry **110,** of an electrical connection between a battery pack **200** and a traction system **12** of a vehicle **10** at a first switching frequency **351** of a set of predetermined switching frequencies **350,** synchronously obtain a first cell voltage **321** and a first cell current **331** of a battery cell **210** of the battery pack **200.** The processing circuitry **110** is further configured to provide the first cell voltage **321,** the first cell current **331** and the first switching frequency **351** for diagnostic of the battery cell **210.**

With reference to **FIG. 7****,** a method **400** for providing EIS data **341** from a battery pack **200** or battery cell **210** will be presented. The method is advantageously a computer implemented method **400.** The processing circuitry **110** of the previously presented computer system **100** may be configured to perform, or cause the performance of, some or all features of the method **400.** It should be mentioned that the method **400** is only described in short for reasons of brevity and the method **400** may very well be expanded, modified or otherwise altered to comprise any of the further features, functions or examples presented herein; specifically those presented in reference to the EIS controller **300** in **FIG. 5****.**

The method **400** comprises controlling **410** a connection between a battery pack **200** and a traction system **12** of a vehicle **10** at a first switching frequency **351** of a set of predetermined switching frequencies **350.** The controlling **410** may advantageously be performed as exemplified in reference to the switch controller **310** introduced in reference to **FIG. 5****.** The method **400** further comprises, during the controlling **410,** synchronously obtaining **420** a first cell voltage **321** and a first cell current **331** of a battery cell **210** of the battery pack **200.** The obtaining **420** may advantageously be performed as exemplified in reference to the voltage obtainer **320** and/or the current obtainer **330** of the EIS controller **310** introduced in reference to **FIG. 5****.** The method **400** further comprises providing **430** the first cell voltage **321,** the first cell current **331** and the first switching frequency **351** for diagnostic of the battery cell **210.** The providing **420** may advantageously be performed as exemplified in reference to the data processor **340** introduced in reference to **FIG. 5****.**

As mentioned, the method **400** may very well be expanded to comprise any other feature presented herein, such as some or all features introduced in reference to the load controller **370** or any other feature of the EIS controller **300.**

In FIG. **8****,** an exemplary energy storage system **500** is shown. The energy storage system **500** comprises one or more battery packs **200.** The battery packs **200** may be any suitable battery pack **200** presented herein. The energy storage system **500** further comprises at least one controllable connection **205** between the battery pack **200** and a load **12.** The load **12** may be a traction system **12** of a vehicle **10.** The controllable connection **205** is advantageously the previously presented switch device **205.** The energy storage system **500** further comprises the previously presented computer system **100** and processing circuitry **110** configured to provide or cause, e.g. any function, feature or example presented in reference to the EIS controller **300.**

In **FIG. 9****,** a block diagram of a vehicle **10** comprising a traction system **12** operatively connected to the energy storage system **500** introduced with reference to **FIG. 8****.**

Although the present disclosure has been focused on providing EIS data **341** at a system level. The features of the computer system **100** and associated processing circuitry **110** presented herein may very well be applied on lower levels as well. To this end, **FIG. 10** shows a battery pack **200** composing at least one battery cell **210** connectable to an external load **12** by a switch device **205.** The battery pack **200** of **FIG. 10** further comprises the computer system **100,** or at least part of the processing circuitry **110** of the computer system 100 presented herein.

In **FIG. 11** a computer program product **600** is shown. The computer program product **600** comprises a computer program **800** and a non-transitory computer readable medium **700.** The computer program **800** may be stored on the computer readable medium **700.** The computer readable medium **700** is, in **FIG. 11****,** exemplified as a vintage **5,25"** floppy disc, but may be embodied as any suitable non-transitory computer readable medium such as, but not limited to, hard disk drives (HDDs), solid-state drives (SSDs), optical discs (e.g., CD-ROM, DVD-ROM, CD-RW, DVD-RW), USB flash drives, magnetic tapes, memory cards, Read-Only Memories (ROM), network-attached storage (NAS), cloud storage etc.

The computer program **800** comprises instruction **810** e.g. program instruction, software code, that, when executed by processing circuitry cause the processing circuitry to perform the method **400** introduced with reference to **FIG. 7****.**

**FIG. 12** is a schematic diagram of a computer system **900** for implementing examples disclosed herein. The computer system **900** of **FIG. 12** may be the computer system **100** introduced with reference to **FIG. 1****.** The computer system **900** is adapted to execute instructions from a computer-readable medium to perform these and/or any of the functions or processing described herein. The computer system **900** may be connected (e.g., networked) to other machines in a LAN, an intranet, an extranet, or the Internet. While only a single device is illustrated, the computer system **900** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **900** may comprise at least one computing device or electronic device capable of including firmware, hardware, and/or executing software instructions to implement the functionality described herein. The computer system **900** may include processing circuitry **902** (e.g., processing circuitry including one or more processor devices or control units), a memory **904,** and a system bus **906.** The processing circuitry **902** may be the processing circuitry **110** introduced in reference to **FIG. 2****.** The computer system **900** may include at least one computing device having the processing circuitry **902.** The system bus **906** provides an interface for system components including, but not limited to, the memory **904** and the processing circuitry **902.** The processing circuitry **902** may include any number of hardware components for conducting data or signal processing or for executing computer code stored in memory **904.** The processing circuitry **902** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **902** may further include computer executable code that controls operation of the programmable device.

The system bus **906** may be any of several types of bus structures that may further interconnect to a memory bus (with or without a memory controller), a peripheral bus, and/or a local bus using any of a variety of bus architectures. The memory **904** may be one or more devices for storing data and/or computer code for completing or facilitating methods described herein. The memory **904** may include database components, object code components, script components, or other types of information structure for supporting the various activities herein. Any distributed or local memory device may be utilized with the systems and methods of this description. The memory **904** may be communicably connected to the processing circuitry **902** (e.g., via a circuit or any other wired, wireless, or network connection) and may include computer code for executing one or more processes described herein. The memory **904** may include non-volatile memory **908** (e.g., read-only memory (ROM), erasable programmable read-only memory (EPROM), electrically erasable programmable read-only memory (EEPROM), etc.), and volatile memory **910** (e.g., random-access memory (RAM)), or any other medium which can be used to carry or store desired program code in the form of machine-executable instructions or data structures and which can be accessed by a computer or other machine with processing circuitry **902.** A basic input/output system (BIOS) **912** may be stored in the non-volatile memory **908** and can include the basic routines that help to transfer information between elements within the computer system **900.**

The computer system **900** may further include or be coupled to a non-transitory computer-readable storage medium such as the storage device **914,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **914** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **914** and/or in the volatile memory **910,** which may include an operating system **916** and/or one or more program modules **918.** All or a portion of the examples disclosed herein may be implemented as a computer program **920** stored on a transitory or non-transitory computer-usable or computer-readable storage medium (e.g., single medium or multiple media), such as the storage device **914,** which includes complex programming instructions (e.g., complex computer-readable program code) to cause the processing circuitry **902** to carry out actions described herein. Thus, the computer-readable program code of the computer program **920** can comprise software instructions for implementing the functionality of the examples described herein when executed by the processing circuitry **902.** In some examples, the storage device **914** may be a computer program product (e.g., readable storage medium) storing the computer program **920** thereon, where at least a portion of a computer program **920** may be loadable (e.g., into a processor) for implementing the functionality of the examples described herein when executed by the processing circuitry **902.** The processing circuitry **902** may serve as a controller or control system for the computer system **900** that is to implement the functionality described herein.

The computer system **900** may include an input device interface **922** configured to receive input and selections to be communicated to the computer system **900** when executing instructions, such as from a keyboard, mouse, touch-sensitive surface, etc. Such input devices may be connected to the processing circuitry **902** through the input device
interface **922** coupled to the system bus **906** but can be connected through other interfaces, such as a parallel port, an Institute of Electrical and Electronic Engineers (IEEE) **1394** serial port, a Universal Serial Bus (USB) port, an IR interface, and the like. The computer system **900** may include an output device interface **924** configured to forward output, such as to a display, a video display unit (e.g., a liquid crystal display (LCD) or a cathode ray tube (CRT)). The computer system **900** may include a communications interface **926** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1. A computer system **100** comprising processing circuitry **110** configured to: during control, by the processing circuitry **110,** of an electrical connection between a battery pack **200** and a traction system **12** of a vehicle **10** at a first switching frequency **351** of a set of predetermined switching frequencies **350,** synchronously obtain a first cell voltage **321** and a first cell current **331** of a battery cell **210** of the battery pack **200;** and provide the first cell voltage **321,** the first cell current **331** and the first switching frequency **351** for diagnostic of the battery cell **210.**

Example 2. The computer system **100** of example 1, wherein the processing circuitry **110** is further configured to: during control, by the processing circuitry **110,** of an electrical connection between a battery pack **200** and a traction system **12** of a vehicle **10** at each additional switching frequency **353** of the set of predetermined switching frequencies **350,** for each additional switching frequency **353,** synchronously obtain an additional cell voltage **322** and an additional cell current **332** of a battery cell **210** of the battery pack **200;** and provide the additional cell voltages **322,** the additional cell currents **332** and their associated additional switching frequencies **353** for diagnostic of the battery cell **210.**

Example 3. The computer system **100** of example **1** or **2,** wherein the set of predetermined switching frequencies **350**first switching frequency **351** comprise one or more frequencies between 0,1 Hz to 10 kHz.

Example 4. The computer system **100** of any one of examples 1 to 3, wherein the processing circuitry **110** is further configured to: control the electrical connection between the battery pack **200** and the traction system **12** by controlling pre-charge transistor circuitry **203** of the battery pack **200.**

Example 5. The computer system **100** of example 4, wherein the processing circuitry **110** is further configured to, prior to obtaining the cell voltages **321, 322** and cell currents **331, 332:** control the traction system **12** to provide a short circuit to the battery pack 200; and control the pre-charge transistor circuitry **203** to limit currents from the battery pack 200.

Example 6. The computer system **100** of any one of examples 1 to 5, wherein the processing circuitry **110** is further configured to, prior to obtaining the cell voltages **321, 322** and cell currents **331, 332:** control the traction system **12** to provide a discharge load to the battery pack **200.**

Example 7. The computer system **100** of any one of examples 2 to 6, wherein the processing circuitry **110** is further configured to: obtain a plurality of first cell voltages **321, 322** as a series of first cell voltages **321, 322,** a plurality of first cell currents **331** as a series of first cell currents **331, 332** synchronous to the series of first cell voltages **321, 322;** obtain, for each additional frequency **353** of the set of predetermined switching frequencies **350,** additional cell voltages **322** as a series of additional cell voltages **322** and a plurality of additional cell currents **332** as a series of additional cell currents **332** synchronous to the series of additional cell voltages **322,** filter the series of first cell voltages **321** and the series of first cell currents **331** by a first filter **361,** wherein the first filter **361** is tuned to the first switching frequency **351,** and filter, for each additional frequency **353** of the set of predetermined switching frequencies **350,** the series of additional cell voltage **322** and the series additional cell currents **332** by an additional filter **363,** wherein the additional filter **363** is tuned to the associated additional switching frequency **353.**

Example 8. The computer system **100** of example 7, wherein the first filter **361** and the additional filters **363** are the same tunable filter **360** and the processing circuitry **110** is further configured to tune the tunable filter **360** based on the switching frequency **351, 353.**

Example 9. The computer system **100** of any one of examples 1 to 8, wherein the processing circuitry **110** is further configured to: process the first cell voltage **321** and the first cell current **331** to provide a first frequency internal resistance of the battery cell **210,** and provide the first frequency internal resistance for diagnostic of the battery cell **210.**

Example 10. The computer system **100** of any one of examples 1 to 9, wherein the processing circuitry **110** is further configured to: diagnose the battery pack **200** based on the obtained cell voltage/s **321, 322,** the obtained cell current/s **331, 332** and their associated switching frequency/ies **351, 353,** preferably by determining current state of health, SOH, of the battery pack **200** and compare the current SOH to a previous SOH of the battery pack **200.**

Example 11. The computer system **100** of any one of examples 1 to 10, wherein the processing circuitry **110** is further configured to: control operation of the battery pack **200** based on the obtained cell voltage/s **321, 322,** the obtained cell current/s **331, 332** and their associated switching frequency/ies **351, 353.**

Example 12. The computer system **100** of example 1, wherein the processing circuitry **110** is further configured to: during control, by the processing circuitry **110,** of an electrical connection between a battery pack **200** and a traction system **12** of a vehicle **10** at each additional switching frequency **353** of the set of predetermined switching frequencies **350,** for each additional switching frequency **353,** synchronously obtain an additional cell voltage **322** and an additional cell current **332** of a battery cell **210** of the battery pack **200;** and provide the additional cell voltages **322,** the additional cell currents **332** and their associated additional switching frequencies **353** for diagnostic of the battery cell **210;** wherein the set of predetermined switching frequencies **350**first switching frequency **351** comprise one or more frequencies between 0,1 Hz to 10 kHz; wherein the processing circuitry **110** is further configured to: control the electrical connection between the battery pack **200** and the traction system **12** by controlling pre-charge transistor circuitry **203** of the battery pack **200;** wherein the processing circuitry **110** is further configured to, prior to obtaining the cell voltages **321, 322** and cell currents **331, 332:** control the traction system **12** to provide a short circuit to the battery pack **200;** and control the pre-charge transistor circuitry **203** to limit currents from the battery pack **200;** wherein the processing circuitry **110** is further configured to, prior to obtaining the cell voltages **321, 322** and cell currents **331, 332:** control the traction system **12** to provide a discharge load to the battery pack **200;** wherein the processing circuitry **110** is further configured to: obtain a plurality of first cell voltages **321, 322** as a series of first cell voltages **321, 322,** a plurality of first cell currents **331** as a series of first cell currents **331, 332** synchronous to the series of first cell voltages **321, 322;** obtain, for each additional frequency **353** of the set of predetermined switching frequencies **350,** additional cell voltages **322** as a series of additional cell voltages **322** and a plurality of additional cell currents **332** as a series of additional cell currents **332** synchronous to the series of additional cell voltages **322,** filter the series of first cell voltages **321** and the series of first cell currents **331** by a first filter **361,** wherein the first filter **361** is tuned to the first switching frequency **351,** and filter, for each additional frequency **353** of the set of predetermined switching frequencies **350,** the series of additional cell voltage **322** and the series additional cell currents **332** by an additional filter **363,** wherein the additional filter **363** is tuned to the associated additional switching frequency **353;** wherein the first filter **361** and the additional filters **363** are the same tunable filter **360** and the processing circuitry **110** is further configured to tune the tunable filter **360** based on the switching frequency **351, 353;** wherein the processing circuitry **110** is further configured to: process the first cell voltage **321** and the first cell current **331** to provide a first frequency internal resistance of the battery cell **210,** and provide the first frequency internal resistance for diagnostic of the battery cell **210;** wherein the processing circuitry **110** is further configured to: diagnose the battery pack **200** based on the obtained cell voltage/s **321, 322,** the obtained cell current/s **331, 332** and their associated switching frequency/ies **351, 353,** preferably by determining current state of health, SOH, of the battery pack **200** and compare the current SOH to a previous SOH of the battery pack **200;** wherein the processing circuitry **110** is further configured to: control operation of the battery pack **200** based on the obtained cell voltage/s **321, 322,** the obtained cell current/s **331, 332** and their associated switching frequency/ies **351, 353.**

Example 13. An energy storage system **500** comprising at least one battery pack **200,** at least one controllable connection **205** between the at least one battery pack **200** and a load **12** and the computer system **100** of any one of examples 1 to 12 operatively connected to the controllable connection **205.**

Example 14. A vehicle **10,** comprising a battery pack **200,** a traction system **12** and the energy storage system of example 13.

Example 15. The vehicle **10** of example 14, wherein the vehicle is a heavy-duty vehicle 10.

Example 16. A computer implemented method **400** comprising: controlling **410,** by processing circuitry **110** of a computer system **100,** an electrical connection between a battery pack **200** and a traction system **12** of a vehicle **10** at a first switching frequency **351** of a set of predetermined switching frequencies **350,** during control of the electrical connection, synchronously obtaining **420,** by the processing circuitry **110** of the computer system **100,** a first cell voltage **321** and a first cell current **331** of a battery cell **210** of the battery pack **200;** and providing **430,** by the processing circuitry **110** of the computer system **100,** the first cell voltage **321,** the first cell current **331** and the first switching frequency **351** for diagnostic of the battery cell **210.**

Example 17. The computer implemented method **400** of example 16, further comprising: controlling **410,** by the processing circuitry **110** of the computer system **100,** the electrical connection between the battery pack **200** and the traction system **12** of the vehicle **10** at each additional switching frequency **353** of the set of predetermined switching frequencies **350;** and during control of the electrical connection, for each additional switching frequency **353,** synchronously obtaining **420,** by the processing circuitry **110** of the computer system **100,** an additional cell voltage **322** and an additional cell current **332** of a battery cell 210 of the battery pack **200;** and providing **430,** by the processing circuitry **110** of the computer system **100,** the additional cell voltages **322,** the additional cell currents **332** and their associated additional switching frequencies **353** for diagnostic of the battery cell **210.**

Example 18. The computer implemented method **400** of example 16 or 17, wherein the set of predetermined switching frequencies **350** comprise one or more frequencies between 0,1 Hz to 10 kHz.

Example 19. The computer implemented method **400** of any one of examples 16 to 18 further comprising: controlling **410,** by the processing circuitry **110** of the computer system **100,** the electrical connection between the battery pack **200** and the traction system **12** by controlling pre-charge transistor circuitry **203** of the battery pack **200.**

Example 20. The computer implemented method **400** of example 19, further comprising, prior to obtaining **420** the cell voltages **321, 322** and cell currents **331, 332:** controlling, by the processing circuitry **110** of the computer system **100,** the traction system **12** to provide a short circuit to the battery pack **200;** and controlling, by the processing circuitry **110** of the computer system **100,** the pre-charge transistor circuitry **203** to limit currents from the battery pack **200.**

Example 21. The computer implemented method **400** of any one of examples 16 to 20 further comprising, prior to obtaining **420** the cell voltages **321, 322** and cell currents **331, 332:** controlling, by the processing circuitry **110** of the computer system **100,** the traction system **12** to provide a discharge load to the battery pack **200.**

Example 22. The computer implemented method **400** of any one of examples 17 to 21 further comprising: obtaining **420,** by the processing circuitry **110** of the computer system **100,** a plurality of first cell voltages **321, 322** as a series of first cell voltages **321, 322,** a plurality of first cell currents **331** as a series of first cell currents **331, 332** synchronous to the series of first cell voltages **321, 322;** obtaining **420,** by the processing circuitry **110** of the computer system **100,** for each additional frequency **353** of the set of predetermined switching frequencies **350,** additional cell voltages **322** as a series of additional cell voltages **322** and a plurality of additional cell currents **332** as a series of additional cell currents **332** synchronous to the series of additional cell voltages **322,** filtering, by the processing circuitry **110** of the computer system **100,** the series of first cell voltages **321** and the series of first cell currents **331** by a first filter **361,** wherein the first filter **361** is tuned to the first switching frequency **351,** and filtering, by the processing circuitry **110** of the computer system **100,** for each additional frequency **353** of the set of predetermined switching frequencies **350,** the series of additional cell voltage **322** and the series additional cell currents **332** by an additional filter **363,** wherein the additional filter **363** is tuned to the associated additional switching frequency **353.**

Example 23. The computer implemented method **400** of example 22, wherein the first filter **361** and the additional filters **363** are the same tunable filter **360** and the method **400** further comprises: tuning, by the processing circuitry **110** of the computer system **100,** the tunable filter **360** based on the switching frequency **351, 353.**

Example 24. The computer implemented method **400** of any one of examples 17 to 23 further comprising: processing, by the processing circuitry **110** of the computer system **100,** the first cell voltage **321** and the first cell current **331** to provide a first frequency internal resistance of the battery cell **210,** and providing **430,** by the processing circuitry **110** of the computer system **100,** the first frequency internal resistance for diagnostic of the battery cell **210.**

Example 25. The computer implemented method **400** of any one of examples 16 to 24 further comprising: diagnosing, by the processing circuitry **110** of the computer system **100,** the battery pack **200** based on the obtained cell voltage/s **321, 322,** the obtained cell current/s **331, 332** and their associated switching frequency/ies **351, 353,** preferably by determining current state of health, SOH, of the battery pack **200** and compare the current SOH to a previous SOH of the battery pack **200.**

Example 26. The computer implemented method **400** of any one of examples 16 to 25 further comprising: controlling **410,** by the processing circuitry **110** of the computer system **100,** operation of the battery pack **200** based on the obtained cell voltage/s **321, 322,** the obtained cell current/s **331, 332** and their associated switching frequency/ies **351, 353.**

Example 27. A computer program product comprising program code for performing, when executed by the processing circuitry, the computer implemented method 400 of any one of examples 16 to 26.

Example 28. A non-transitory computer-readable storage medium comprising instructions, which when executed by the processing circuitry, cause the processing circuitry to perform the computer implemented method **400** of any one of examples 16 to 26.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system **(100)** comprising processing circuitry **(110)** configured to:
during control, by the processing circuitry **(110),** of an electrical connection between a battery pack **(200)** and a traction system **(12)** of a vehicle **(10)** at a first switching frequency **(351)** of a set of predetermined switching frequencies **(350),** synchronously obtain a first cell voltage **(321)** and a first cell current **(331)** of a battery cell **(210)** of the battery pack **(200);** and
provide the first cell voltage **(321),** the first cell current (331) and the first switching frequency **(351)** for diagnostic of the battery cell **(210).**

2. The computer system **(100)** of claim 1, wherein the processing circuitry **(110)** is further configured to:
during control, by the processing circuitry **(110),** of an electrical connection between a battery pack **(200)** and a traction system **(12)** of a vehicle **(10)** at each additional switching frequency **(353)** of the set of predetermined switching frequencies **(350),** for each additional switching frequency **(353),** synchronously obtain an additional cell voltage **(322)** and an additional cell current **(332)** of a battery cell **(210)** of the battery pack **(200);** and
provide the additional cell voltages **(322),** the additional cell currents **(332)** and their associated additional switching frequencies **(353)** for diagnostic of the battery cell **(210).**

3. The computer system **(100)** of claim 1 or 2, wherein the set of predetermined switching frequencies **(350)** comprise one or more frequencies between 0,1 Hz to 10 kHz.

4. The computer system **(100)** of any one of claims 1 to 3, wherein the processing circuitry **(110)** is further configured to: control the electrical connection between the battery pack **(200)** and the traction system **(12)** by controlling pre-charge transistor circuitry **(203)** of the battery pack **(200).**

5. The computer system **(100)** of claim 4, wherein the processing circuitry **(110)** is further configured to, prior to obtaining the cell voltages **(321, 322)** and cell currents **(331, 332):**
control the traction system **(12)** to provide a short circuit to the battery pack **(200);** and
control the pre-charge transistor circuitry **(203)** to limit currents from the battery pack **(200).**

6. The computer system **(100)** of any one of claims 2 to 5, wherein the processing circuitry **(110)** is further configured to:
obtain a plurality of first cell voltages **(321, 322)** as a series of first cell voltages **(321, 322),** a plurality of first cell currents **(331)** as a series of first cell currents **(331, 332)** synchronous to the series of first cell voltages **(321, 322);**
obtain, for each additional frequency **(353)** of the set of predetermined switching frequencies **(350),** additional cell voltages **(322)** as a series of additional cell voltages **(322)** and a plurality of additional cell currents **(332)** as a series of additional cell currents **(332)** synchronous to the series of additional cell voltages **(322),**
filter the series of first cell voltages **(321)** and the series of first cell currents **(331)** by a first filter **(361),** wherein the first filter **(361)** is tuned to the first switching frequency **(351),** and
filter, for each additional frequency **(353)** of the set of predetermined switching frequencies **(350),** the series of additional cell voltages **(322)** and the series additional cell currents **(332)** by an additional filter **(363),** wherein the additional filter **(363)** is tuned to the associated additional switching frequency **(353).**

7. The computer system **(100)** of any one of claims 1 to 6, wherein the processing circuitry **(110)** is further configured to:
diagnose the battery pack **(200)** based on the obtained cell voltage/s **(321, 322),** the obtained cell current/s **(331, 332)** and their associated switching frequency/ies **(351, 353),** preferably by determining current state of health, SOH, of the battery pack **(200)** and compare the current SOH to a previous SOH of the battery pack **(200).**

8. The computer system **(100)** of any one of claims 1 to 7, wherein the processing circuitry **(110)** is further configured to:
control operation of the battery pack **(200)** based on the obtained cell voltage/s **(321, 322),** the obtained cell current/s **(331, 332)** and their associated switching frequency/ies **(351, 353).**

9. The computer system **(100)** of claim **1** wherein the processing circuitry **(110)** is further configured to: during control, by the processing circuitry **(110),** of an electrical connection between a battery pack **(200)** and a traction system **(12)** of a vehicle **(10)** at each additional switching frequency **(353)** of the set of predetermined switching frequencies **(350),** for each additional switching frequency **(353),** synchronously obtain an additional cell voltage **(322)** and an additional cell current **(332)** of a battery cell **(210)** of the battery pack **(200);** and provide the additional cell voltages **(322),** the additional cell currents **(332)** and their associated additional switching frequencies **(353)** for diagnostic of the battery cell **(210);** control the electrical connection between the battery pack **(200)** and the traction system **(12)** by controlling pre-charge transistor circuitry **(203)** of the battery pack **(200);** control the traction system **(12)** to provide a short circuit to the battery pack **(200);** and control the pre-charge transistor circuitry **(203)** to limit currents from the battery pack **(200);** obtain a plurality of first cell voltages **(321, 322)** as a series of first cell voltages **(321, 322),** a plurality of first cell currents **(331)** as a series of first cell currents **(331, 332)** synchronous to the series of first cell voltages **(321, 322);** obtain, for each additional frequency **(353)** of the set of predetermined switching frequencies **(350),** additional cell voltages **(322)** as a series of additional cell voltages **(322)** and a plurality of additional cell currents **(332)** as a series of additional cell currents **(332)** synchronous to the series of additional cell voltages **(322),** filter the series of first cell voltages **(321)** and the series of first cell currents **(331)** by a first filter **(361),** wherein the first filter **(361)** is tuned to the first switching frequency **(351),** and filter, for each additional frequency **(353)** of the set of predetermined switching frequencies **(350),** the series of additional cell voltage **(322)** and the series additional cell currents **(332)** by an additional filter **(363),** wherein the additional filter **(363)** is tuned to the associated additional switching frequency **(353);** diagnose the battery pack **(200)** based on the obtained cell voltage/s **(321, 322),** the obtained cell current/s **(331, 332)** and their associated switching frequency/ies **(351, 353),** preferably by determining current state of health, SOH, of the battery pack **(200)** and compare the current SOH to a previous SOH of the battery pack **(200);** control operation of the battery pack **(200)** based on the obtained cell voltage/s **(321, 322),** the obtained cell current/s **(331, 332)** and their associated switching frequency/ies **(351, 353);** wherein the set of predetermined switching frequencies **(350)** comprise one or more frequencies between 0,1 Hz to 10 kHz; and wherein the processing circuitry **(110)** is further configured to: process the first cell voltage **(321)** and the first cell current **(331)** to provide a first frequency internal resistance of the battery cell **(210),** and provide the first frequency internal resistance for diagnostic of the battery cell **(210).**

10. An energy storage system **(500)** comprising at least one battery pack **(200),** at least one controllable connection **(205)** between the at least one battery pack **(200)** and a load **(12)** and the computer system **(100)** of any one of claims 1 to 9 operatively connected to the controllable connection **(205).**

11. A vehicle **(10),** a traction system **(12)** and the energy storage system of claim 10 connected to the traction system **(12).**

12. A computer implemented method **(400)** comprising:
controlling **(410),** by processing circuitry **(110)** of a computer system **(100),** an electrical connection between a battery pack **(200)** and a traction system **(12)** of a vehicle **(10)** at a first switching frequency **(351)** of a set of predetermined switching frequencies **(350),**
during control of the electrical connection, synchronously obtaining **(420),** by the processing circuitry **(110)** of the computer system **(100),** a first cell voltage **(321)** and a first cell current **(331)** of a battery cell **(210)** of the battery pack **(200);** and
providing **(430),** by the processing circuitry **(110)** of the computer system **(100),** the first cell voltage **(321),** the first cell current **(331)** and the first switching frequency **(351)** for diagnostic of the battery cell **(210).**

13. The computer implemented method **(400)** of claim 12, further comprising:
controlling **(410),** by the processing circuitry **(110)** of the computer system **(100),** the electrical connection between the battery pack **(200)** and the traction system **(12)** of the vehicle **(10)** at each additional switching frequency **(353)** of the set of predetermined switching frequencies **(350);** and
during control of the electrical connection, for each additional switching frequency **(353),** synchronously obtaining **(420),** by the processing circuitry **(110)** of the computer system **(100),** an additional cell voltage **(322)** and an additional cell current **(332)** of a battery cell **(210)** of the battery pack **(200);** and
providing **(430),** by the processing circuitry **(110)** of the computer system **(100),** the additional cell voltages **(322),** the additional cell currents **(332)** and their associated additional switching frequencies **(353)** for diagnostic of the battery cell **(210).**

14. A computer program product **(600)** comprising program code **(810)** for performing, when executed by a processing circuitry **(110),** the computer implemented method **(400)** of any one of claims 12 or 13.

15. A non-transitory computer-readable storage medium **(700)** comprising instructions **(810),** which when executed by a processing circuitry **(110),** cause the processing circuitry **(110)** to perform the computer implemented method **(400)** of any one of claims 12 or 13.

## Amended claims

### Amended claims in accordance with Rule 137(2) EPC.

1. A computer system (**100**) comprising processing circuitry (**110**) configured to:
during control, by the processing circuitry (**110**), of an electrical connection between a battery pack (**200**) and a traction system (**12**) of a vehicle (**10**) at a first switching frequency (**351**) of a set of predetermined switching frequencies (**350**), synchronously obtain a first cell voltage (**321**) and a first cell current (**331**) of a battery cell (**210**) of the battery pack (**200**); and
provide the first cell voltage (**321**), the first cell current (**331**) and the first switching frequency (**351**) for diagnostic of the battery cell (**210**); **characterized in that** the processing circuitry (**110**) is further configured to:
control the electrical connection between the battery pack (**200**) and the traction system (**12**) by controlling pre-charge transistor circuitry (**203**) of the battery pack (**200**).

2. The computer system (**100**) of claim 1, wherein the processing circuitry (**110**) is further configured to:
during control, by the processing circuitry (**110**), of an electrical connection between a battery pack (**200**) and a traction system (**12**) of a vehicle (**10**) at each additional switching frequency (**353**) of the set of predetermined switching frequencies (**350**), for each additional switching frequency (**353**), synchronously obtain an additional cell voltage (**322**) and an additional cell current (**332**) of a battery cell (**210**) of the battery pack (**200**); and
provide the additional cell voltages (**322**), the additional cell currents (**332**) and their associated additional switching frequencies (**353**) for diagnostic of the battery cell (**210**).

3. The computer system (**100**) of claim 1 or 2, wherein the set of predetermined switching frequencies (**350**) comprise one or more frequencies between 0,1 Hz to 10 kHz.

4. The computer system (**100**) of any of claims 1-3, wherein the processing circuitry (**110**) is further configured to, prior to obtaining the cell voltages (**321, 322**) and cell currents (**331, 332**):
control the traction system (**12**) to provide a short circuit to the battery pack (**200**); and
control the pre-charge transistor circuitry (**203**) to limit currents from the battery pack (**200**).

5. The computer system (**100**) of any one of claims 2 to 4, wherein the processing circuitry (**110**) is further configured to:
obtain a plurality of first cell voltages (**321, 322**) as a series of first cell voltages (**321**, **322**), a plurality of first cell currents (**331**) as a series of first cell currents (**331**, **332**) synchronous to the series of first cell voltages (**321**, **322**);
obtain, for each additional frequency (**353**) of the set of predetermined switching frequencies (**350**), additional cell voltages (**322**) as a series of additional cell voltages (**322**) and a plurality of additional cell currents (**332**) as a series of additional cell currents (**332**) synchronous to the series of additional cell voltages (**322**),
filter the series of first cell voltages (**321**) and the series of first cell currents (**331**) by a first filter (**361**), wherein the first filter (**361**) is tuned to the first switching frequency (**351**), and
filter, for each additional frequency (**353**) of the set of predetermined switching frequencies (**350**), the series of additional cell voltages (**322**) and the series additional cell currents (**332**) by an additional filter (**363**), wherein the additional filter (**363**) is tuned to the associated additional switching frequency (**353**).

6. The computer system (**100**) of any one of claims 1 to 5, wherein the processing circuitry (**110**) is further configured to:
diagnose the battery pack (**200**) based on the obtained cell voltage/s (**321, 322**), the obtained cell current/s (**331**, **332**) and their associated switching frequency/ies (**351, 353**), preferably by determining current state of health, SOH, of the battery pack (**200**) and compare the current SOH to a previous SOH of the battery pack (**200**).

7. The computer system (**100**) of any one of claims 1 to 6, wherein the processing circuitry (**110**) is further configured to:
control operation of the battery pack (**200**) based on the obtained cell voltage/s (**321**, **322**), the obtained cell current/s (**331**, **332**) and their associated switching frequency/ies (**351**, **353**).

8. The computer system (**100**) of claim **1** wherein the processing circuitry (**110**) is further configured to: during control, by the processing circuitry (**110**), of an electrical connection between a battery pack (**200**) and a traction system (**12**) of a vehicle (**10**) at each additional switching frequency (**353**) of the set of predetermined switching frequencies (**350**), for each additional switching frequency (**353**), synchronously obtain an additional cell voltage (**322**) and an additional cell current (**332**) of a battery cell (**210**) of the battery pack (**200**); and provide the additional cell voltages (**322**), the additional cell currents (**332**) and their associated additional switching frequencies (**353**) for diagnostic of the battery cell (**210**); control the electrical connection between the battery pack (**200**) and the traction system (**12**) by controlling pre-charge transistor circuitry (**203**) of the battery pack (**200**); control the traction system (**12**) to provide a short circuit to the battery pack (**200**); and control the pre-charge transistor circuitry (**203**) to limit currents from the battery pack (**200**); obtain a plurality of first cell voltages (**321**, **322**) as a series of first cell voltages (**321**, **322**), a plurality of first cell currents (**331**) as a series of first cell currents (**331**, **332**) synchronous to the series of first cell voltages (**321**, **322**); obtain, for each additional frequency (**353**) of the set of predetermined switching frequencies (**350**), additional cell voltages (**322**) as a series of additional cell voltages (**322**) and a plurality of additional cell currents (**332**) as a series of additional cell currents (**332**) synchronous to the series of additional cell voltages (**322**), filter the series of first cell voltages (**321**) and the series of first cell currents (**331**) by a first filter (**361**), wherein the first filter (**361**) is tuned to the first switching frequency (**351**), and filter, for each additional frequency (**353**) of the set of predetermined switching frequencies (**350**), the series of additional cell voltage (**322**) and the series additional cell currents (**332**) by an additional filter (**363**), wherein the additional filter (**363**) is tuned to the associated additional switching frequency (**353**); diagnose the battery pack (**200**) based on the obtained cell voltage/s (**321**, **322**), the obtained cell current/s (**331**, **332**) and their associated switching frequency/ies (**351**, **353**), preferably by determining current state of health, SOH, of the battery pack (**200**) and compare the current SOH to a previous SOH of the battery pack (**200**); control operation of the battery pack (**200**) based on the obtained cell voltage/s (**321**, **322**), the obtained cell current/s (**331**, **332**) and their associated switching frequency/ies (**351**, **353**); wherein the set of predetermined switching frequencies (**350**) comprise one or more frequencies between 0,1 Hz to 10 kHz; and wherein the processing circuitry (**110**) is further configured to: process the first cell voltage (**321**) and the first cell current (**331**) to provide a first frequency internal resistance of the battery cell (**210**), and provide the first frequency internal resistance for diagnostic of the battery cell (**210**).

9. An energy storage system (**500**) comprising at least one battery pack (**200**), at least one controllable connection (**205**) between the at least one battery pack (**200**) and a load (**12**) and the computer system (**100**) of any one of claims 1 to 8 operatively connected to the controllable connection (**205**).

10. A vehicle (**10**), a traction system (**12**) and the energy storage system of claim 9 connected to the traction system (**12**).

11. A computer implemented method (**400**) comprising:
controlling (**410**), by processing circuitry (**110**) of a computer system (**100**), an electrical connection between a battery pack (**200**) and a traction system (**12**) of a vehicle (**10**) at a first switching frequency (**351**) of a set of predetermined switching frequencies (**350**),
during control of the electrical connection, synchronously obtaining (**420**), by the processing circuitry (**110**) of the computer system (**100**), a first cell voltage (**321**) and a first cell current (**331**) of a battery cell (**210**) of the battery pack (**200**);
providing (**430**), by the processing circuitry (**110**) of the computer system (**100**), the first cell voltage (**321**), the first cell current (**331**) and the first switching frequency (**351**) for diagnostic of the battery cell (**210**); and
controlling (**410**), by the processing circuitry (**110**) of the computer system (**100**), the electrical connection between the battery pack (**200**) and the traction system (**12**) by controlling pre-charge transistor circuitry (**203**) of the battery pack (**200**).

12. The computer implemented method (**400**) of claim 11, further comprising:
controlling (**410**), by the processing circuitry (**110**) of the computer system (**100**), the electrical connection between the battery pack (**200**) and the traction system (**12**) of the vehicle (**10**) at each additional switching frequency (**353**) of the set of predetermined switching frequencies (**350**); and
during control of the electrical connection, for each additional switching frequency (**353**), synchronously obtaining (**420**), by the processing circuitry (**110**) of the computer system (**100**), an additional cell voltage (**322**) and an additional cell current (**332**) of a battery cell (**210**) of the battery pack (**200**); and
providing (**430**), by the processing circuitry (**110**) of the computer system (**100**), the additional cell voltages (**322**), the additional cell currents (**332**) and their associated additional switching frequencies (**353**) for diagnostic of the battery cell (**210**).

13. A computer program product (**600**) comprising program code (**810**) for performing, when executed by a processing circuitry (**110**), the computer implemented method (**400**) of any one of claims 11 or 12.

14. A non-transitory computer-readable storage medium (700) comprising instructions (810), which when executed by a processing circuitry (110), cause the processing circuitry (110) to perform the computer implemented method (400) of any one of claims 11 or 12.
